# EUROPÄISCHE PATENTANMELDUNG

(11) **EP 1 326 256 A2**
(43) Veröffentlichungstag der Anmeldung: **09.07.2003**
(21) Anmeldenummer: 02102859.2
(22) Anmeldetag: 20.12.2002
(51) Int. Cl.: G11C 16/10, G11C 16/34

(54) **Verfahren und Anordnung zur Programmierung und Verifizierung von EEPROM-Pages sowie ein entsprechendes Computerprogrammprodukt und ein entsprechendes computerlesbares Speichermedium**

(30) Priorität: 29.12.2001 DE 10164415
(71) Anmelder: Philips Intellectual Property & Standards GmbH, 20099 Hamburg (DE); Koninklijke Philips Electronics N.V., 5621 BA Eindhoven (NL)
(72) Erfinder: Buhr, Wolfgang, 52088, Aachen (DE)
(74) Vertreter: Volmer, Georg, Dipl.-Ing.

(57) **Zusammenfassung**

Die Erfindung beschreibt ein Verfahren und eine Anordnung zur Programmierung und Verifizierung von EEPROM-Pages sowie ein entsprechendes Computerprogrammprodukt und ein entsprechendes computerlesbares Speichermedium, welche insbesondere genutzt werden können, um die Programmierung von größeren Mengen von Daten beziehungsweise Code in den EEPROM, wie es beispielsweise bei der Personalisierung von Smartcards der Fall ist, zu beschleunigen.

Die Erfindung beschreibt eine Anordnung, die eine DMA Verbindung zwischen EEPROM und RAM - unter Ausschluss des beteiligten Microcontroller Cores einrichtet und ein automatisches Programmieren von Datenblöcken beliebiger Länge aus dem RAM in das EEPROM inklusive der Veeifikation des Programmiervorgangs mit den Originaldaten im RAM unter Kontrolle der EEPROM-Logik ermöglicht.

## Beschreibung

Die Erfindung betrifft ein Verfahren und eine Anordnung zur Programmierung und Verifizierung von EEPROM-Pages sowie ein entsprechendes Computerprogrammprodukt und ein entsprechendes computerlesbares Speichermedium, welche insbesondere genutzt werden können, um die Programmierung von größeren Mengen von Daten beziehungsweise Code in den EEPROM, wie es beispielsweise bei der Personalisierung von Smartcards der Fall ist, zu beschleunigen.

Die Entwicklung der Mikroelektronik in den 70er-Jahren ermöglichte es, kleine Computer im Kreditkartenformat ohne Benutzungsschnittstelle herzustellen. Solche Computer werden als Smartcards bezeichnet. In einer Smartcard sind Datenspeicher und arithmetisch-logische Einheiten in einem einzigen Chip von wenigen Quadratmillimetern Größe integriert. Smartcards werden insbesondere als Telefonkarten, GSM-SIM-Karten, im Bankenbereich und im Gesundheitswesen eingesetzt. Die Smartcard ist damit zur allgegenwärtigen Rechenplattform geworden.

Smartcards werden derzeit vornehmlich als sicherer Aufbewahrungsort für geheime Daten und als sichere Ausführungsplattform für kryptographische Algorithmen betrachtet. Die Annahme einer relativ hohen Sicherheit der Daten und Algorithmen auf der Karte liegt im Hardwareaufbau der Karte und den nach außen geführten Schnittstellen begründet. Die Karte stellt sich nach außen als "Black Box" dar, deren Funktionalität nur über eine wohldefinierte Hardware- und Softwareschnittstelle in Anspruch genommen werden kann, und die bestimmte Sicherheitspolicies erzwingen kann. Zum einen kann der Zugriff auf Daten an bestimmte Bedingungen geknüpft werden. Kritische Daten, wie zum Beispiel geheime Schlüssel eines Public-Key-Verfahrens, können dem Zugriff von außen sogar völlig entzogen werden. Zum anderen ist eine Smartcard in der Lage, Algorithmen auszuführen, ohne dass die Ausführung der einzelnen Operationen von außen beobachtet werden kann. Die Algorithmen selbst können auf der Karte vor Veränderung und Auslesen geschützt werden. Im objektorientierten Sinn lässt sich die Smartcard als abstrakter Datentyp auffassen, der über eine wohldefinierte Schnittstelle verfügt, ein spezifiziertes Verhalten aufweist und selbst in der Lage ist, die Einhaltung bestimmter Integritätsbedingungen bezüglich seines Zustandes sicherzustellen.

Es gibt im Wesentlichen zwei verschiedene Typen von Smartcards. Speicherkarten besitzen lediglich eine serielle Schnittstelle, eine Adressierungs- und Sicherheitslogik und ROM- und EEPROM-Speicher. Diese Karten besitzen nur eingeschränkte Funktionalität und dienen einer spezifischen Anwendung. Dafür sind sie besonders billig herzustellen. Als Mikroprozessorkarten hergestellte Smartcards stellen im Prinzip einen vollständigen Universalrechner dar.

Der Herstellungs- und Auslieferungsprozess für Chipkarten gliedert sich in folgende Phasen:
- Herstellen des Halbleiters,
- Einbetten des Halbleiters,
- Bedrucken der Karte,
- Personalisierung der Karte,
- Ausgeben der Karte.

Im Allgemeinen wird jede Phase von einer auf die jeweilige Arbeit spezialisierten Firma durchgeführt. Beim Herstellen der Halbleiter ist insbesondere bei Karten mit festverdrahteter Sicherheitslogik auf eine gute betriebsinterne Sicherheit zu achten. Damit vom Hersteller ein korrekter Endtest durchgeführt werden kann, muss der komplette Speicher frei zugänglich sein. Erst nach dem Endtest wird der Chip durch einen Transportcode gesichert. Danach ist der Zugriff auf den Kartenspeicher nur für berechtigte Stellen, die den Transportcode kennen, möglich. Ein Diebstahl fabrikneuer Halbleiter bleibt damit ohne Folgen. Berechtigte Stellen können Personalisierer beziehungsweise Kartenausgeber sein. Für das Einbetten und Bedrucken sind keine weiteren Sicherungsfunktionen notwendig. Die betreffenden Firmen brauchen den Transportcode nicht zu kennen.

Im Allgemeinen überträgt nicht der Kartenhersteller, sondern die ausgebende Stelle (zum Beispiel Bank, Telefongesellschaft, Krankenkasse etc.) die personenspezifischen Daten in die Karte. Diesen Vorgang nennt man Personalisierung. Für sie ist die Kenntnis des Transportcodes notwendig.

Das Ausgeben der Karte, also der Transport von der ausgebenden Stelle zum Karteninhaber, stellt ein weiteres Sicherheitsproblem dar. Genau genommen ist nur die persönliche Ausgabe an den Karteninhaber gegen Unterschrift und Vorlage des Personalausweises sicher. Ein Versand per Post ist zwar oft wirtschaftlicher, aber auch ziemlich unsicher. Ein Problem ist auch das Übermitteln der PIN an den Karteninhaber, hier muss die gleiche Sorgfalt wie für die Karte gelten.

Bedingt durch die brisanten, sicherheitsrelevanten Inhalte der auf Smartcard-Controllern befindlichen Speicher ist neben der Beachtung dieser Sicherungsmaßnahmen ein zusätzlicher Schutz gegen mögliche Aktivitäten von Hackern zu gewährleisten, die sich auf alle Phasen des Lebenslaufes einer Smartcard - beginnend von der Herstellung, über Transport, Nutzung der Karte bis zu Manipulationen unbrauchbar gewordener Karten - erstrecken.

Bei der Programmierung von größeren Mengen von Daten/Code in das EEPROM (zum Beispiel bei der Personalisierung) entsteht ein relativ großer Zeitverlust einerseits durch den Datentransport via SFR-Bus, andererseits durch die notwendige Verifikation der geschriebenen EEPROM-Daten nach dem Programmieren jeder Page.

Bisher war es notwendig, zum Beispiel bei einer Personalisierung des EEPROM, die einzelnen Schritte (Auslesen des RAMs, Schreiben der Page in das EEPROM Page Register, erneutes Auslesen der programmierten Bytes aus dem EEPROM und Vergleich mit den Sollwerten aus dem RAM) per Software durchzuführen, d.h. dass ein erheblicher Anteil der Zeit, die zum Beschreiben des Page Registers und zum Verifizieren der programmierten Page benötigt wird, durch Bustransfers und Register-Instruktionen benötigt wird.

Werden große Memory-Bereiche, zum Beispiel bei der Personalisierung eines EEPROMs mit Anwendercode, beschrieben, erweist es sich als nachteilig, dass sich auf die ohnehin beträchtliche Programmierzeit des EEPROM pro Page die zusätzlichen Zeiten für das Füllen des Page-Registers und das Verifizieren des programmierten Page addieren.

Für den Datentransfer zwischen EEPROM, ROM und RAM sind verschiedene Methoden bekannt.

Im US-Patent 5,802,268 wird eine Anordnung offenbart, die den Datenzugriff auf einen Controller mit angegliederten ROM, RAM und EEPROM Speichern beschreibt.

Das US-Patent 5,778,440 stellt eine Anordnung zur Verifizierung von in ein EEPROM programmierten Daten vor. Es bezieht sich ausschließlich auf die Kontrolllogik des EEPROM-Speichers selbst und daher auch nur auf dessen Komponenten Page-Register, Speichermatrix und Programmier-/Verifizierlogik. Es beschreibt somit eine reine Verifizierlogik des EEPROMs, nicht aber ein besonderes Verfahren der Datenübertragung welches insbesondere auch das RAM einbezieht.

Das deutsche Patent DE 43 44 379 A1 betrifft ein Verfahren zur Programmierung eines in einer Mikroprozessorschaltung angeordneten EPROM-Bausteins, dessen Speicherkapazität teilweise als Programmspeicher für einen mit dem EPROM-Baustein über eine Busleitung verbundenen Mikroprozessor genutzt wird, wobei die freie Speicherkapazität des EPROM-Bausteins durch aus dem Mikroprozessor unmittelbar in den EPROM-Baustein übertragene Daten belegt wird und die Datenübertragung im Adress- und Datenbus durch Anhalten der Taktung des Mikroprozessors während des gesamten Programmiervorgangs eingefroren wird.

Es wird hier also lediglich eine Anordnung zum Programmieren eines EEPROMs in einer Controller-Architektur vorgestellt.

Der Erfindung liegt die Aufgabe zugrunde, ein Verfahren, eine Anordnung sowie ein entsprechendes Computerprogrammprodukt und ein entsprechendes computerlesbares Speichermedium der gattungsgemäßen Art anzugeben, durch welche die Nachteile der herkömmlichen Vorgehensweisen vermieden werden und durch welche es ermöglicht wird, in kürzestmöglicher Zeit Daten vom RAM in das Page Register des EEPROMs zu schreiben und nach dem Programmiervorgang automatisch zu verifizieren. Dabei soll der Hardware-Aufwand im EEPROM-Interface minimal sein.

Erfindungsgemäß wird diese Aufgabe gelöst durch die Merkmale im kennzeichnenden Teil der Ansprüche 1, 10, 12 und 13 im Zusammenwirken mit den Merkmalen im Oberbegriff. Zweckmäßige Ausgestaltungen der Erfindung enthalten die Unteransprüche.

Ein besonderer Vorteil des Verfahrens zur Programmierung und Verifizierung von EEPROM-Pages liegt darin, dass in einem ersten Schritt Datenworte einer vorgegebenen Länge aus dem RAM gelesen und in das Page Register geschrieben werden, in einem zweiten Schritt der Programmiervorgang für diese Datenworte ausgeführt wird und in einem dritten Schritt die Datenworte erneut aus dem RAM und die programmierten Datenworte aus dem EEPROM gelesen und verifiziert werden, wobei die Schritte Eins bis Drei solange wiederholt werden, bis die Programmierung des EEPROM abgeschlossen ist.

Eine Anordnung zur Programmierung und Verifizierung von EEPROM-Pages ist vorteilhaft so eingerichtet, dass sie einen Prozessor umfasst, der derart eingerichtet ist, dass eine Programmierung und Verifizierung von EEPROM-Pages durchführbar ist, indem in einem ersten Schritt Datenworte einer vorgegebenen Länge aus dem RAM gelesen und in das Page Register geschrieben werden, in einem zweiten Schritt der Programmiervorgang für diese Datenworte ausgeführt wird und in einem dritten Schritt die Datenworte erneut aus dem RAM und die programmierten Datenworte aus dem EEPROM gelesen und verifiziert werden, wobei die Schritte Eins bis Drei solange wiederholt werden, bis die Programmierung des EEPROM abgeschlossen ist.

Ein Computerprogrammprodukt zur Programmierung und Verifizierung von EEPROM-Pages umfasst ein computerlesbares Speichermedium, auf dem ein Programm gespeichert ist, das es einem Computer oder Smartcard-Controller ermöglicht, nachdem es in den Speicher des Computers oder des Smartcard-Controllers geladen worden ist, eine Programmierung und Verifizierung von EEPROM-Pages durchzuführen, indem in einem ersten Schritt Datenworte einer vorgegebenen Länge aus dem RAM gelesen und in das Page Register geschrieben werden, in einem zweiten Schritt der Programmiervorgang für diese Datenworte ausgeführt wird und in einem dritten Schritt die Datenworte erneut aus dem RAM und die programmierten Datenworte aus dem EEPROM gelesen und verifiziert werden, wobei die Schritte Eins bis Drei solange wiederholt werden, bis die Programmierung des EEPROM abgeschlossen ist.

Um eine Programmierung und Verifizierung von EEPROM-Pages durchzuführen, wird vorteilhaft ein computerlesbares Speichermedium eingesetzt, auf dem ein Programm gespeichert ist, das es einem Computer oder Smartcard-Controller ermöglicht, nachdem es in den Speicher des Computers oder des Smartcard-Controllers geladen worden ist, die Programmierung und Verifizierung von EEPROM-Pages durchzuführen, indem in einem ersten Schritt Datenworte einer vorgegebenen Länge aus dem RAM gelesen und in das Page Register geschrieben werden, in einem zweiten Schritt der Programmiervorgang für diese Datenworte ausgeführt wird und in einem dritten Schritt die Datenworte erneut aus dem RAM und die programmierten Datenworte aus dem EEPROM gelesen und verifiziert werden, wobei die Schritte Eins bis Drei solange wiederholt werden, bis die Programmierung des EEPROM abgeschlossen ist. Hierbei ist es besonders vorteilhaft, dass die Schaltungsanordnung PVU diese Programmier/Verifizier-Funktion in HW-Funktion ausführt und somit Teile des ansonsten notwendigen Programmes ersetzt.

Vorteilhaft erhält beim erfindungsgemäßen Verfahren das EEPROM-Interface während der Zyklen des Programmier- und Verifiziervorgangs direkten Speicherzugriff ("Direct Memory Access" = "DMA") auf das RAM, das Adressen-Kontroll-Register und das Datenwort-Längen-Register.

Als vorteilhaft erweist es sich, dass vor Beginn der Zyklen des Programmier- und Verifizierungsvorgangs RAM Addr-Daten in das Start-Adressen-SFR 7 der PVU geladen und die Programmier- und Verifizierungssequenz durch eine Meldung an das Control/Status SFR der PVU gestartet wird.

In bevorzugter Ausgestaltung des erfindungsgemäßen Verfahrens ist vorgesehen, dass die Start-Adresse des im ersten Schritt zu lesenden Datenwortes im RAM vom SFR der Programmier- und Verifizier-Einheit definiert wird. Eine weitere vorteilhafte Ausgestaltung des erfindungsgemäßen Verfahrens besteht darin, dass die Start-Adresse des im zweiten Schritt zu programmierenden Datenwortes im EEPROM durch EADRX SFRs definiert wird. Bei dem Verfahren zur Programmierung und Verifizierung von EEPROM-Pages erweist es sich als vorteilhaft, dass die vorgegebene Länge des im ersten Schritt zu lesenden Datenwortes vom Control/Status SFR 6 der PVU definiert wird. Ebenso erweist es sich als vorteilhaft, dass die Verifikation der programmierten Datenworte vom Control/Status SFR der PVU ausgeführt wird.

Ein weiterer Vorteil des erfindungsgemäßen Verfahrens besteht darin, dass die Verifikation der programmierten Datenworte wortweise erfolgt. Als vorteilhaft erweist es sich ausserdem, dass das RAM-Interface eine Prioritätslogik aufweist, welche den CPU-Zugriff auf das RAM während der Zyklen des Programmier- und Verifizierungsvorgangs kontrolliert und erforderlichenfalls verzögert oder untersagt.

Darüber hinaus ist in bevorzugter Ausgestaltung der erfindungsgemäßen Anordnung vorgesehen, dass der Prozessor Teil eines Smartcard-Controllers und die Anordnung eine Smartcard ist.

Die Erfindung umfasst eine Anordnung, die den Datenspeicher (RAM), aus dem das Page-Register des EEPROM gefüllt wird, mit in die Anordnung einbezieht, wofür als ein wesentlicher Teil der Erfindung zwischen diesem RAM und dem EEPROM eine DMA-Verbindung (für direkten Speicherzugriff = "Direct Memory Access") eingeführt wird, die unter Kontrolle der EEPROM-Logik steht, und es so ermöglicht, auch grössere Datenblöcke aus dem RAM, die das Fassungsvermögen des EEPROM-Pageregister um ein Vielfaches übersteigen, unter Kontrolle der EEPROM-Logik zu programmieren und zu verifizieren. Die Erfindung geht also in der Funktion weiter als die bisher praktizierten Verfahren.

Die Erfindung beschreibt eine Anordnung, die eine DMA-Verbindung zwischen EEPROM und RAM - unter Ausschluss des beteiligten Mikrocontroller-Cores- einrichtet und ein automatisches Programmieren von Datenblöcken beliebiger Länge aus dem RAM in das EEPROM inklusive der Verifikation des Programmiervorgangs mit den Originaldaten im RAM unter Kontrolle der EEPROM-Logik ermöglicht.

Diese Methode hat gegenüber der bisherigen Personalisierungsfunktion einen starken Geschwindigkeitsvorteil, da der maximale Schreib/Lese-Takt ausschließlich vom Zugriffs-"Timing" des EEPROMs abhängt. Zusätzliche Verzögerungen durch SFR-Bus-Handshake oder Compare-Commands entfallen.

Die Verifikation der programmierten Bytes durch zweimaliges Lesen des RAM Bereiches vermeidet ein Doppeln des Page Registers im EEPROM Interface und minimiert dadurch den Hardware-Aufwand.

Die Erfindung wird nachfolgend in einem Ausführungsbeispiel anhand der zugehörigen Zeichnung, die eine EEPROM-Programmier- und -Verifiziereinheit (PVU) zeigt, näher erläutert.

Für die Durchführung des Programmier- und Verifizierungsvorgangs erhält ein EEPROM-Interface 2 DMA (direkten Speicherzugriff) auf ein RAM 1 und zwei zusätzliche Control-Register, die die Basisadresse "Baddr" im RAM 1 und die Länge des zu programmierenden Datenbereiches "PagLen" (höchstens Länge eines Page Registers 8) angeben.

Die "Page Programm & Verify Unit" (FSM) im EEPROM-Interface 2 kontrolliert den Ablauf des Page Programmings in drei Phasen:
Phase 1: Lesen von PagLen-Datenworten aus dem RAM 1 und Schreiben dieser Worte in das Page Register 8. Die Page Adresse im EEPROM wird dabei von den SFRs EADR2..0 bestimmt.
Phase 2: Starten des Programmiervorgangs.
Phase 3: Erneutes Lesen derselben Datenworte aus dem RAM 1, gleichzeitiges Lesen der programmierten Worte aus dem EEPROM und wortweises Verifizieren der programmierten Daten.

Das RAM Interface muss eine Prioritäkslogik erhalten, die den CPU-Zugriff auf das RAM 1 während der EEPROM-Programm & Verify-Zyklen bremst oder untersagt.

Vor dem Start der Zyklen des Programmier- und Verifizierungsvorgangs wird das Startadressen-SFR der PVU mit den RAM addr-Daten geladen und der Programmier- und Verifizierungsvorgang durch eine Meldung an das Control/Status-SFR 6 der PVU gestartet.

Die Erfindung ist nicht beschränkt auf die hier dargestellten Ausführungsbeispiele. Vielmehr ist es möglich, durch Kombination und Modifikation der genannten Mittel und Merkmale weitere Ausführungsvarianten zu realisieren, ohne den Rahmen der Erfindung zu verlassen.

### BEZUGSZEICHENLISTE

- 1: RAM
- 2: EEPROM-Interface
- 3: CNTRL
- 4: Adressengenerator
- 5: RAM/EEPROM Data Comparator
- 6: Control/Status SFR der Programmier- und Verifizierungseinheit (PVU)
- 7: RAM-Startadressen-Pointer SFR der PVU
- 8: (128-Byte) Page Register
- 9: EEPROM-Matrix

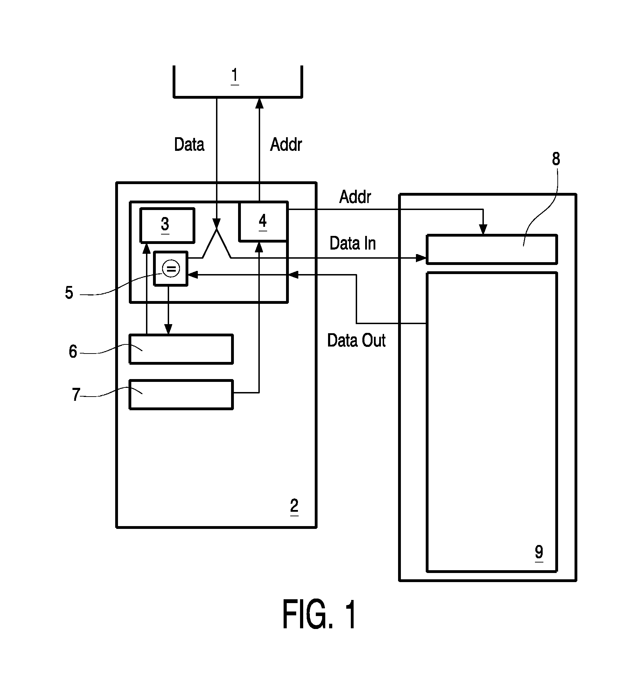

## Patentansprüche

1. Verfahren zur Programmierung und Verifizierung von EEPROM-Pages,
**dadurch gekennzeichnet,**
**dass** in einem ersten Schritt Datenworte einer vorgegebenen Länge aus dem RAM (1) gelesen und in das Page Register (8) geschrieben werden, in einem zweiten Schritt der Programmiervorgang für diese Datenworte ausgeführt wird und in einem dritten Schritt die Datenworte erneut aus dem RAM (1) und die programmierten Datenworte aus dem EEPROM gelesen und verifiziert werden, wobei die Schritte Eins bis Drei solange wiederholt werden, bis die Programmierung des EEPROM abgeschlossen ist.

2. Verfahren nach Anspruch 1,
**dadurch gekennzeichnet,**
**dass** das EEPROM-Interface (2) während der Zyklen des Programmier- und Verifiziervorgangs Direct Memory Access (DMA) auf das RAM (1), das Adressen-Kontroll-Register und das Datenwort-Längen-Register erhält.

3. Verfahren nach einem der vorhergehenden Ansprüche,
**dadurch gekennzeichnet,**
**dass** vor Beginn der Zyklen des Programmier- und Verifizierungsvorgangs RAM addr-Daten in das Start-Adressen-SFR (7) der PVU geladen und die Programmier- und Verifizierungssequenz durch eine Meldung an das Control/Status SFR (6) der PVU gestartet wird.

4. Verfahren nach einem der vorhergehenden Ansprüche,
**dadurch gekennzeichnet,**
**dass** die Start-Adresse des im ersten Schritt zu lesenden Datenwortes im RAM (1) vom SFR der Programmier- und Verifizier-Einheit definiert wird.

5. Verfahren nach einem der vorhergehenden Ansprüche,
**dadurch gekennzeichnet,**
**dass** die Start-Adresse des im zweiten Schritt zu programmierenden Datenwortes im EEPROM durch EADRX SFRs definiert wird.

6. Verfahren nach einem der vorhergehenden Ansprüche,
**dadurch gekennzeichnet,**
**dass** die vorgegebene Länge des im ersten Schritt zu lesenden Dakenwortes vom Control/Status SFR (6) der PVU definiert wird.

7. Verfahren nach einem der vorhergehenden Ansprüche,
**dadurch gekennzeichnet,**
**dass** die Verifikation der programmierten Datenworte vom Control/Status SFR (6) der PVU ausgeführt wird.

8. Verfahren nach einem der vorhergehenden Ansprüche,
**dadurch gekennzeichnet,**
**dass** die Verifikation der programmierten Datenworte wortweise erfolgt.

9. Verfahren nach einem der vorhergehenden Ansprüche,
**dadurch gekennzeichnet,**
**dass** das RAM-Interface (2) eine Prioritätslogik aufweist, welche den CPU-Zugriff auf das RAM (1) während der Zyklen des Programmier- und Verifizierungsvorgangs kontrolliert und erforderlichenfalls verzögert oder untersagt.

10. Anordnung mit einem Prozessor, der derart eingerichtet ist, dass die Programmierung und Verifizierung von EEPROM-Pages durchführbar ist, indem in einem ersten Schritt Datenworte einer vorgegebenen Länge aus dem RAM (1) gelesen und in das Page Register (8) geschrieben werden, in einem zweiten Schritt der Programmiervorgang für diese Datenworte ausgeführt wird und in einem dritten Schritt die Datenworte erneut aus dem RAM (1) und die programmierten Datenworte aus dem EEPROM gelesen und verifiziert werden, wobei die Schritte Eins bis Drei solange wiederholt werden, bis die Programmierung des EEPROM abgeschlossen ist.

11. Anordnung mit einem Prozessor nach Anspruch 10,
**dadurch gekennzeichnet,**
**dass** der Prozessor Teil eines Smartcard-Controllers und die Anordnung eine Smartcard ist.

12. Computerprogrammprodukt, das ein computerlesbares Speichermedium umfasst, auf dem ein Programm gespeichert ist, das es einem Computer oder Smartcard-Controller ermöglicht, nachdem es in den Speicher des Computers oder des Smartcard-Controllers geladen worden ist, die Programmierung und Verifizierung von EEPROM-Pages durchzuführen, indem in einem ersten Schritt Datenworte einer vorgegebenen Länge aus dem RAM (1) gelesen und in das Page Register (8) geschrieben werden, in einem zweiten Schritt der Programmiervorgang für diese Datenworte ausgeführt wird und in einem dritten Schritt die Datenworte erneut aus dem RAM (1) und die programmierten Datenworte aus dem EEPROM gelesen und verifiziert werden, wobei die Schritte Eins bis Drei solange wiederholt werden, bis die Programmierung des EEPROM abgeschlossen ist.

13. Computerlesbares Speichermedium, auf dem ein Programm gespeichert ist, das es einem Computer oder Smartcard-Controller ermöglicht, nachdem es in den Speicher des Computers oder des Smartcard-Controllers geladen worden ist, die Programmierung und Verifizierung von EEPROM-Pages durchzuführen, indem in einem ersten Schritt Datenworte einer vorgegebenen Länge aus dem RAM (1) gelesen und in das Page Register (8) geschrieben werden, in einem zweiten Schritt der Programmiervorgang für diese Datenworte ausgeführt wird und in einem dritten Schritt die Datenworte erneut aus dem RAM (1) und die programmierten Datenworte aus dem EEPROM gelesen und verifiziert werden, wobei die Schritte Eins bis Drei solange wiederholt werden, bis die Programmierung des EEPROM abgeschlossen ist.
